# EUROPÄISCHE PATENTANMELDUNG

(11) **EP 1 962 301 A1**
(43) Veröffentlichungstag der Anmeldung: **27.08.2008**
(21) Anmeldenummer: 07003696.7
(22) Anmeldetag: 23.02.2007
(51) Int. Cl.: H01F 29/12

(54) **Element für ein Anpassungsnetzwerk, Anpassungsnetzwerk und Verwendung desselben**

(71) Anmelder: HÜTTINGER Elektronik GmbH + Co. KG, 79111 Freiburg (DE)
(72) Erfinder: Creutzburg, Michael, 68600 Biesheim (FR)
(74) Vertreter: Kohler Schmid Möbus

(57) **Zusammenfassung**

Ein Element (2) für ein Anpassungsnetzwerk (1), insbesondere ein Anpassungsnetzwerk zum Anpassen einer Eingangsimpedanz eines ersten Schaltungsteils an eine Ausgangsimpedanz eines zweiten Schaltungsteils, speziell zum Anpassen der Last einer Plasmaentladungseinrichtung an einen geeigneten Hochfrequenz-Leistungsgenerator, umfasst wenigstens eine Spule (6, 8), die bei Stromdurchfluss ein magnetisches Feld (H) ausbildet, und wenigstens einen Körper (9, 10) aus einem elektrisch leitfähigen Material, der zum Bewirken einer Änderung des magnetischen Felds der Spule gegenüber der Spule beweglich angeordnet ist.

## Beschreibung

Die Erfindung betrifft ein Anpassungsnetzwerk zum Anpassen einer Eingangsimpedanz eines ersten Schaltungsteils an eine Ausgangsimpedanz eines zweiten Schaltungsteils, eine Verwendung desselben sowie ein Element für ein Anpassungsnetzwerk.

Bei dem Betrieb einer HF-Plasmaentladungseinrichtung, beispielsweise für die Anregung eines CO₂-Lasers, muss die Einrichtung, in der die Entladung stattfindet und die somit eine Last und einen ersten Schaltungsteil mit einer bestimmten Eingangsimpedanz darstellt, an eine Ausgangsimpedanz eines zugehörigen zweiten Schaltungsteils, insbesondere eines Hochfrequenz (HF)-Frequenzgenerators (HF-Leistungsgenerator), angepasst werden. Dies geschieht durch ein Anpassungsnetzwerk, welches geeignet zwischen den Generator und die Last geschaltet wird und das zum Einstellen seiner Impedanz beziehungsweise seines Transformationsverhaltens eine Anzahl von Spulen und Kondensatoren beinhaltet, die in ihrer Induktivität beziehungsweise Kapazität veränderbar sind. Das Anpassungsnetzwerk ist dabei regelmäßig aus Sicherheitsgründen in einem Gehäuse angeordnet.

Zum Ändern der Induktivität einer Spule eines solchen Anpassungsnetzwerks ist es nach dem Stand der Technik üblich, eine Länge der Spule durch Metallklemmen zu verändern. Hierzu muss das Gehäuse des Anpassungsnetzwerks geöffnet werden, um anschließend die Metallklemmen zu lösen, zu verschieben und wieder an der Spule zu befestigen. Hierfür ist in nachteiliger Weise ein erheblicher Zeitaufwand erforderlich. Darüber hinaus weist ein derartiges vorbekanntes Anpassungsnetzwerk eine relativ hohe Verlustleistung auf, da sich aufgrund der eingesetzten Metallklemmen in den Spulen Kurzschlusswindungen ergeben.

Der Erfindung liegt das technische Problem zu Grunde, ein Element für ein Anpassungsnetzwerk beziehungsweise ein Anpassungsnetzwerk der eingangs genannten Art dahingehend weiterzuentwickeln, dass eine einfachere Einstellbarkeit bei zugleich verringerter Verlustleistung erreicht wird.

Die Aufgabe wird gemäß einem ersten Aspekt der vorliegenden Erfindung gelöst durch ein Element für ein Anpassungsnetzwerk mit den Merkmalen des Patentanspruchs 1.

Erfindungsgemäß umfasst ein Element für ein Anpassungsnetzwerk wenigstens eine Spule, die bei Stromdurchfluss ein magnetisches Feld ausbildet, und wenigstens einen Körper aus einem elektrisch leitfähigen Material, der zum Bewirken einer Änderung des magnetischen Felds der Spule gegenüber der Spule beweglich angeordnet ist.

Die Aufgabe wird gemäß einem zweiten Aspekt der vorliegenden Erfindung weiterhin gelöst durch ein Anpassungsnetzwerk mit den Merkmalen des Patentanspruchs 16.

Erfindungsgemäß weist ein Anpassungsnetzwerk zum Anpassen einer Eingangsimpedanz eines ersten Schaltungsteils an eine Ausgangsimpedanz eines zweiten Schaltungsteils demnach wenigstens ein Element gemäß dem ersten Aspekt der vorliegenden Erfindung auf.

Gemäß einer bevorzugten Verwendung dient das erfindungsgemäße Anpassungsnetzwerk zum Anpassen der Last einer Plasmaentladungseinrichtung an einen geeigneten Hochfrequenz-Leistungsgenerator.

Bevorzugte Weiterbildungen in der vorliegenden Erfindung sind Gegenstand von Unteransprüchen, deren Wortlaut hiermit durch Bezugnahme in die Beschreibung aufgenommen wird, um unnötige Textwiederholungen zu vermeiden.

Gemäß Ausgestaltungen der vorliegenden Erfindung wird der Einsatz eines bezüglich der Spule beweglichen Körpers aus einem elektrisch leitfähigen Material, wie einem Metall, vorgeschlagen. Der Körper kann insbesondere als Platte ausgebildet sein, wobei die Platte vorzugsweise in Form eines Abstimmtellers, das heißt mit kreisförmiger Ausgestaltung (kreisförmigem Umfang) ausgebildet ist. Die vorliegende Erfindung ist jedoch nicht auf eine derartige Ausgestaltung des Körpers beschränkt, sodass auch andere Körper-Formen eingesetzt werden können, z.B. Quader oder Würfel, Kugeln oder kugelähnliche Gebilde usw. Vorteilhafter Weise ist der Körper rotationssymmetrisch ausgebildet (bei einer Platte also beispielsweise mit dem bereits erwähnten kreisförmigen Umfang), worauf weiter unten noch detailliert eingegangen wird.

Der Körper ist zum Bewirken der Änderung des magnetischen Felds der Spule durch Änderung eines Abstandes zwischen Spule und Körper ausgebildet. Mit anderen Worten: das Magnetfeld der Spule, damit ihre Induktivität und folglich die Impedanz eines die Spule enthaltenden Anpassungsnetzwerks wird gemäß einer Ausgestaltung der vorliegenden Erfindung mittels einer Änderung des Abstandes zwischen Spule und Körper bewirkt.

Die Abstandsänderung zwischen Spule und leitfähigem Körper führt zu einer Beeinflussung des magnetischen Feldes, welches die Spule in ihrem stromdurchflossenen Zustand umgibt, und bewirkt so eine Veränderung der Induktivität der Spule (nachfolgend auch als Abstimmung bezeichnet) beziehungsweise der Impedanz des gesamten Anpassungsnetzwerks. Da die erwähnte Induktivitätsänderung zumindest anteilig durch Induzieren von Wirbelströmen in dem Körper hervorgerufen wird, sieht eine Weiterbildung des erfindungsgemäßen Elements vor, dass der Körper eine Form aufweist, die ein Ausbilden von Wirbelströmen ermöglicht oder begünstigt, wenn sich der Körper in dem magnetischen Feld der Spule befindet. Vorteilhafter Weise besitzt der Körper demnach möglichst keine Schlitze, Spalte, Einschnitte, Ausnehmungen oder dgl., die einer Ausbildung von Wirbelströmen und somit der angestrebten Magnetfeldbeeinflussung entgegen wirken könnten.

Der Körper, insbesondere in seiner Ausbildung als Platte bzw. Abstimmteller, kann gemäß Ausgestaltungen der vorliegenden Erfindung auf einem kreiszylindrischen Stab, insbesondere in Form einer Schraube, angebracht sein, der bzw. die sich von dem Körper weg senkrecht zu einer Plattenebene und durch die Wand eines Gehäuses des Anpassungsnetzwerks erstreckt. Auf diese Weise lässt sich durch einfaches Drehen der Schraube der Abstand des Körpers, speziell der Platte beziehungsweise des Abstimmtellers von der Spule verändern, ohne dazu das Gehäuse öffnen zu müssen.

Allerdings muss sich der allgemein als Abstandeinstellteil fungierende kreiszylindrische Stab nicht zwingend senkrecht der zu der genannten Plattenebene oder einer anderen ausgezeichneten Fläche des Körpers erstrecken. Vielmehr kann es zwecks einer gezielten Beeinflussung des Magnetsfelds erwünscht sein, dass sich das Abstandeinstellteil unter einem anderen Winkel als 90° von dem Körper weg erstreckt, um somit über eine Drehung abgesehen von einer Abstandsänderung zusätzlich eine Änderung der relativen Geometrie von Körper und Spule zu erreichen.

Bei dem Gehäuse kann es sich insbesondere um ein für Hochfrequenzstrahlung dichtes Gehäuse (HF-dichtes Gehäuse) handeln, das darüber hinaus aus Sicherheitsgründen geerdet sein kann. Auf diese Weise ist bei einer entsprechenden Weiterbildung der Erfindung eine Verstellbarkeit des Anpassungsnetzwerks von außen möglich, ohne die HF-Dichtheit zu unterbrechen. Vorteilhafter Weise ist somit ein Verstellen während des Betriebs möglich.

Der Ausdruck "HF-dicht" bedeutet in diesem Zusammenhang, dass HF-Strahlung am Ein- und Ausdringen in bzw. aus dem Gehäuse wirkungsvoll gehindert wird. Üblicherweise wird dies durch metallische Gehäuse oder Gehäuse mit elektrisch gut leitfähiger Beschichtung oder Umhüllung erreicht, die keine Schlitze aufweisen oder deren Schlitze deutlich kleiner sind als die kleinste Wellenlänge, die im Gehäuse vorkommt bzw. deren Eindringen in das Gehäuse verhindert werden soll. Die betrifft insbesondere die Arbeitsfrequenz des Anpassungsnetzwerks (beispielsweise im Bereich 3 bis 100 MHz) bzw. die dieser zugeordnete Wellenlänge. Ein "Schlitz" ist hierbei der Abstand zwischen zwei benachbarten elektrischen Verbindungen.

Prinzipiell wäre es zwar möglich, das Gehäuse zu öffnen und dann eine Verstellung im Betrieb vorzunehmen. Allerdings weist die gesamte Anpassungsanordnung im geöffneten Zustand signifikant andere Eigenschaften als im geschlossenen (Betriebs-)Zustand auf. Die vorgenommenen Änderungen würden also beim Schließen des Gehäuses nachteiliger Weise bereits wieder verändert werden. Zudem bestehen gegen ein Öffnen des Gehäuses im Betrieb auch sicherheitstechnische Bedenken.

Die erfindungsgemäße Veränderung der Spuleninduktivität erfolgt demgegenüber berührungslos, schnell und einfach und erfordert keinerlei mechanische Veränderung an der Spule selbst. Das erfindungsgemäße Element für ein Anpassungsnetzwerk beziehungsweise das Anpassungsnetzwerk selbst zeichnet sich dadurch gegenüber dem Stand der Technik zusätzlich auch durch eine vereinfachte Herstellung und geringere Herstellungskosten aus.

Bei der wenigstens einen erfindungsgemäß abstimmbaren Spule kann es sich um eine ebene Spule handeln, die entsprechend eine ausgezeichnete Spulenebene aufweist. In diesem Fall lässt sich insbesondere durch einen seitlich annäherbaren Körper, wie eine seitlich annäherbaren Platte, eine größtmögliche Beeinflussung des Magnetfeldes der Spule erzielen.

Bei Weiterbildungen der Erfindung ist es zur Verstärkung des Effekts möglich, der wenigstens einen Spule auf mehreren Seiten einen Körper, beispielsweise in Form des genannten Abstimmtellers, anzunähern.

Wie bereits ausgeführt, besteht der Körper aus elektrisch leitfähigem Material, beispielsweise aus Metall, vorzugsweise aus Kupfer. Kupfer besitzt einen niedrigen spezifischen Widerstand, weshalb in einem aus Kupfer bestehenden Körper nur geringe Verluste entstehen. Die Änderung der Spuleninduktivität beziehungsweise der Impedanz des Anpassungsnetzwerks wird durch die o.g. Beeinflussung des magnetischen Feldes, quasi durch die Unterbrechung der magnetischen Feldlinien der Spule durch den leitfähigen Körper bewirkt.

Gemäß einer anderen Weiterbildung der Erfindung ist der Körper als Platte und diese vorzugsweise kreisförmig ausgebildet. Somit ergeben sich beim Nähern oder Entfernen der Platte im Zuge der oben genannten Schraubbewegung im Wesentlichen keine Änderungen der Plattengeometrie in Bezug auf die Spule, so dass Störeinflüsse minimiert sind. Der gleiche Effekt lässt sich bei entsprechender Rotationssymmetrie bezogen auf die Achse der Schraubbewegung auch mit anderen Körper-Formen, wie einer Kugel oder einem Segment einer Kugelschale, erreichen.

Vorzugsweise wird bei der vorgeschlagenen Lösung praktisch keine Kapazitätsänderung des Anpassungsnetzwerks bewirkt. Zwar kann durch eine derartige Kapazitätsänderung ebenfalls grundsätzlich eine Induktivitätsänderung in einem Anpassungsnetzwerk erreicht werden, allerdings kommt es dabei zu einer gleichzeitigen Beeinflussung mehrerer Parameter, was bei Impedanz- oder Anpassungsnetzwerken generell unerwünscht ist.

Zudem kann in Weiterbildung der erfindungsgemäßen Lösung der Körper auf Masse liegen oder elektrisch isoliert sein, was ebenfalls Vorteile sicherheitstechnischer Art mit sich bringt.

Weitere Vorteile und Eigenschaften der Erfindung ergeben sich aus der nachfolgenden Beschreibung von Ausführungsbeispielen anhand der Zeichnung. Es zeigt:
- Fig. 1: eine schematische Darstellung eines Anpassungsnetzwerks, das eine Anzahl von erfindungsgemäßen Elementen aufweist;
- Fig. 2: eine schematische Darstellung einer Spule und einem Körper in Form einer Platte aus einem metallischen Material, die bei einem erfindungsgemäßen Element zum Einsatz kommen;
- Fig. 3: eine weitere schematische Darstellung einer Spule und einer Platte gemäß der Fig. 2;
- Fig. 4: eine Querschnittansicht einer Ausgestaltung des erfindungsgemäßen Elements für ein Anpassungsnetzwerk im Zusammenwirken mit einem Gehäuse des Anpassungsnetzwerks; und
- Fig. 5: eine perspektivische Ansicht der Ausgestaltung des erfindungsgemäßen Elements für ein Anpassungsnetzwerk gemäß Fig. 4.

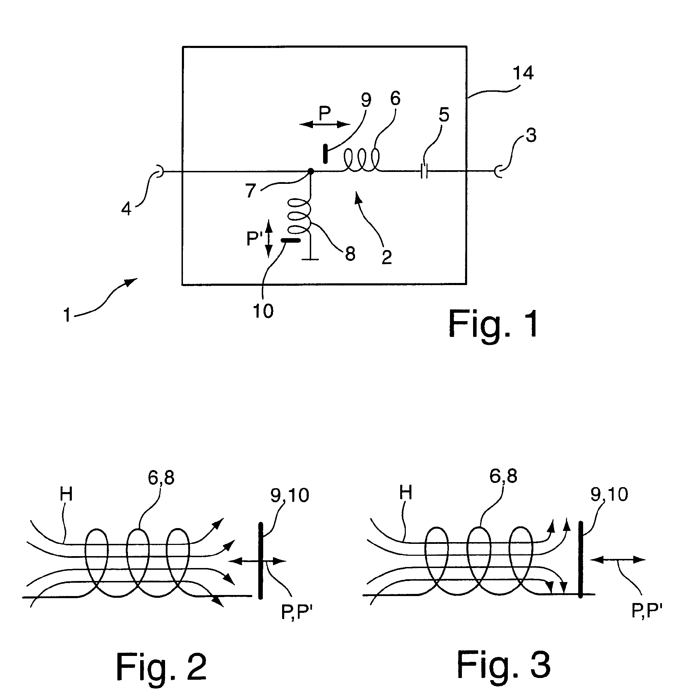

Fig. 1 zeigt eine schematische Darstellung eines Anpassungsnetzwerks 1, das sich in einem HF-dichten Gehäuse 14 befindet und eine Ausgestaltung eines erfindungsgemäßen Elements 2 für ein Anpassungsnetzwerk aufweist. Das Anpassungsnetzwerk 1 dient zum Anpassen der Last einer Plasmaentladungseinrichtung (nicht gezeigt), wie eines CO₂-Lasers, die an einem ersten Anschluss 3 des Anpassungsnetzwerks 1 angeschlossen ist, an einen geeigneten Frequenzgenerator, wie einen Hochfrequenz (HF)-Leistungsgenerator (nicht gezeigt), der an einem zweiten Anschluss 4 des Anpassungsnetzwerks 1 angeschlossen ist und der zum Treiben der Plasmaentladungseinrichtung ausgebildet ist und eine gewisse Ausgangsimpedanz aufweist.

Das Anpassungsnetzwerk 1 weist einen Kondensator 5 und eine erste elektromagnetische Spule 6 auf, die in Reihe zwischen dem ersten Anschluss 3 und dem zweiten Anschluss 4 geschaltet sind. In einem Knoten 7 zwischen der ersten Spule 6 und dem zweiten Anschluss 4 ist parallel zu dem Kondensator 5 und der ersten Spule 6 eine zweite elektromagnetische Spule 8 geschaltet, deren weiterer Anschluss geerdet ist. In der Nähe der jeweiligen Spulen 6, 8 ist bei dem gezeigten Ausführungsbeispiel ein elektrisch leitfähiger Körper in Form einer Platte 9, 10 aus einem metallischen Material angeordnet, die zum Bewirken einer Abstandsänderung gegenüber der jeweiligen Spule 6, 8 in Richtung des jeweiligen Doppelpfeils P, P' beweglich ist.

Die Platten 9, 10 aus einem metallischen Material sind vorzugsweise in Kupfer ausgebildet. Sie bewirken in Abhängigkeit von ihrem jeweiligen Abstand von den Spulen 6, 8 eine Impedanzänderung der jeweiligen Spule durch Beeinflussung des entsprechenden magnetischen Feldes. Dies ist in den Figuren 2 und 3 detaillierter dargestellt.

Fig. 2 zeigt eine schematische Darstellung einer Spule 6, 8 und einer Platte 9, 10 aus einem metallischen Material, die bei einem erfindungsgemäßen Element für ein Anpassungsnetzwerk, insbesondere dem Element 2 gemäß Fig. 1, zum Einsatz kommen. Das Magnetfeld der Spule 6, 8 wird in der Darstellung gemäß Fig. 2 durch eine Anzahl von Magnetfeldlinien H symbolisiert. Die Platte 9, 10 ist mit ihrer Plattenebene im Wesentlichen senkrecht zur Richtung des magnetischen Feldes H am Ort der Platte 9, 10 angeordnet. Wie bereits erwähnt, ist die Platte 9, 10 in Richtung des Doppelpfeils P, P' in einer Richtung beweglich, die im Wesentlichen parallel zur Richtung des magnetischen Feldes H am Ort der Platte 9, 10 verläuft. Auf diese Weise ist durch Bewegen der Platte 9, 10 in Richtung des Doppelpfeils P, P' über die dadurch bewirkte Abstandsänderung zwischen Spule 6, 8 und Platte 9, 10 eine effiziente Beeinflussung des magnetischen Feldes H beziehungsweise dessen Feldlinien erreichbar, wodurch sich erfindungsgemäß eine Impedanzänderung der Spule 6, 8 ergibt, die zum Einstellen des Anpassungsnetzwerks 1 (Fig. 1) verwendbar ist.

Fig. 3 zeigt in einer Darstellung, die im Wesentlichen derjenigen in Fig. 2 entspricht, schematisch die durch eine Abstandsänderung zwischen der Spule 6, 8 und der Platte 9, 10 erreichte Beeinflussung des Magnetfelds H, die zu einer Impedanzänderung der Spule 6, 8 und entsprechend des Anpassungsnetzwerks 1 (Fig. 1) führt.

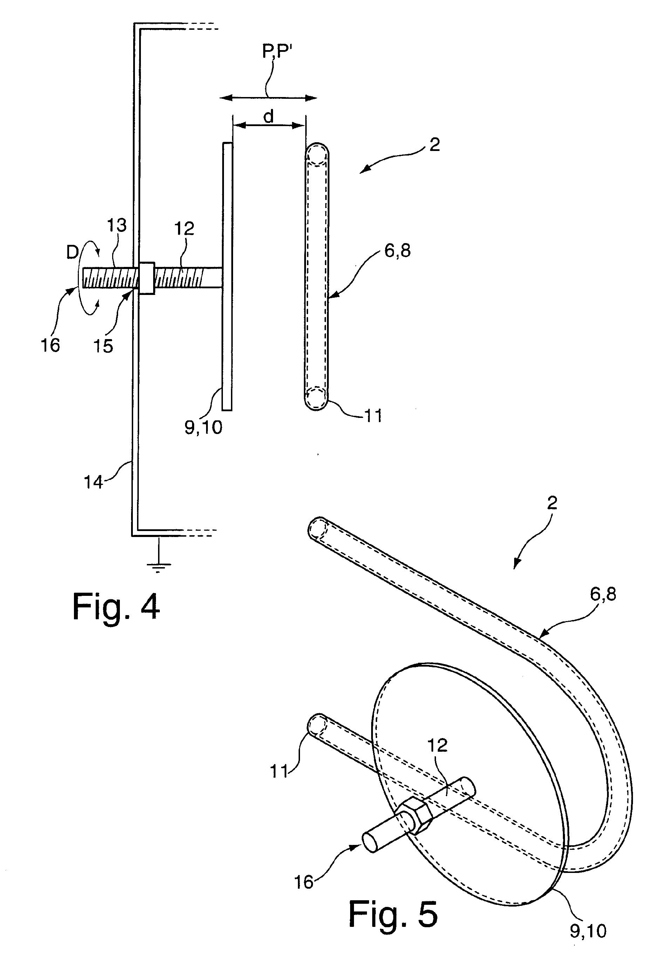

Fig. 4 zeigt eine Querschnittansicht einer Ausgestaltung des erfindungsgemäßen Elements 2 für ein Anpassungsnetzwerk im Zusammenwirken mit einem Gehäuse des Anpassungsnetzwerks, und Fig. 5 zeigt eine perspektivische Ansicht der Ausgestaltung des erfindungsgemäßen Elements 2 für ein Anpassungsnetzwerk gemäß Fig. 4. Gemäß der Darstellung in den Figuren 4 und 5 ist die Spule 6, 8 als ebene Spule aus einem metallischen Rohr 11, vorzugsweise einem Kupferrohr, ausgebildet, das eine insgesamt flache U-förmige Formgebung aufweist und in Betrieb des Anpassungsnetzwerks 1 (Fig. 1) zu Kühlzwecken von einem Fluid, insbesondere von Wasser, durchströmt ist.

Der Körper bzw. die Platte 9, 10 ist im Zuge des gezeigten Ausführungsbeispiels in Form eines kreisförmigen Abstimmtellers ausgebildet, das heißt die Platte 9, 10 weist einen kreisförmigen Umfang und entsprechend eine vollkommene Rotationssymmetrie auf. Sie ist mit ihrer Plattenebene parallel zur Spulenebene der ebenen Spule 6, 8 angeordnet und wiederum in Richtung des Doppelpfeils P, P' (Fig. 4) beweglich. Wie insbesondere aus der Fig. 4 erkennbar ist, entspricht eine äußere Abmessung der Platte 9, 10 im Wesentlichen einer äußeren Abmessung der Spule 6, 8. Mit anderen Worten: ein Abstand zwischen den Schenkeln der U-förmigen Spule 6, 8 entspricht einem Durchmesser des kreisförmigen Abstimmtellers beziehungsweise der Platte 9, 10. Die Abstimmwirkung der Platte 9, 10 wird noch verstärkt, wenn die äußere Abmessung der Platte 9, 10 größer ist als die äußere Abmessung der Spule 6, 8.

Die Platte 9, 10 ist an ihrer der Spule 6, 8 abgewandten Seite mit einem sich senkrecht zur Plattenebene erstreckenden Abstandeinstellteil 12 in Form einer Schraube versehen, die ein Außengewinde 13 aufweist und in Richtung der Symmetrieachse der Platte 9, 10 ausgerichtet ist. Das Außengewinde 13 stellt eine Struktur dar, mittels derer das Abstandeinstellteil 12 für ein Zusammenwirken mit einer komplementären Struktur in Form eines Innengewindes an einem weiteren Element 14 des Anpassungsnetzwerks 1 (Fig. 1) ausgebildet ist. In Fig. 4 ist das weitere Element 14 als ein (HF-dichtes) Gehäuse bzw. als Teil eines Gehäuses für das Anpassungsnetzwerk dargestellt, welches ortsfest in Bezug auf die Spule 6, 8 angeordnet und zudem geerdet ist. Das Gehäuse 14 weist im Bereich einer Durchführung 15 für das Abstandeinstellteil 12 die genannte komplementäre Struktur in Form eines Innengewindes (nicht gezeigt) auf. Auf diese Weise kann durch einfaches Drehen in Richtung des Pfeils D an einem freien Ende 16 des Abstandeinstellteils 12 je nach Drehrichtung eine Abstandsänderung zwischen Platte 9, 10 und Spule 6, 8 in Richtung des Doppelpfeils P, P' von außen bewirkt werden, ohne dass hierzu ein Zugriff auf das weitere Element 14, z.B. ein Öffnen des Gehäuses, erforderlich wäre. Hierbei bleiben Platten- und Spulenebene ständig parallel. Aufgrund der kreisförmigen Ausgestaltung der Platte 9, 10 ergibt sich beim Annähern oder Entfernen derselben bei der genannten der Dreh- oder Schraubbewegung keine Änderung der Plattengeometrie in Bezug auf die Spule 6, 8, wodurch Störeinflüsse minimiert sind.

Im Zuge eines konkreten Ausführungsbeispiels sind sowohl die Spule 6, 8 als auch die Platte 9, 10 in Kupfer ausgebildet, und das Annähern beziehungsweise Entfernen der Platte 9, 10 erfolgt in einem Abstandsbereich d von 5 mm bis 30 mm bezogen auf den Ort der Spule 6, 8.

Die vorstehend unter Bezugnahme auf die Figuren 1 bis 5 dargestellte Platte 9, 10 als spezielle Form des erfindungsgemäß eingesetzten Körpers kann geerdet oder elektrisch isoliert sein. Darüber hinaus können für eine oder mehrere der gezeigten Spulen 6, 8 jeweils eine Mehrzahl von vorzugsweise zwei Körpern / Platten vorgesehen sein, die jeweils auf unterschiedlichen Seiten bezüglich der betreffenden Spule oder Spulen angeordnet sind, um auf diese Weise eine zusätzliche Möglichkeit der Impedanzänderung zu schaffen.

Weiterhin ist die vorliegende Erfindung keinesfalls auf die dargestellten und beschriebenen Ausführungsformen der verwendeten Körper-Formen und Spulen beschränkt. Insbesondere kann eine beziehungsweise können mehrere der verwendeten Spulen eine beliebige Anzahl von Windungen, das heißt eine oder mehrere Windungen aufweisen.

## Patentansprüche

1. Element (2) für ein Anpassungsnetzwerk (1), aufweisend:
wenigstens eine Spule (6, 8), die bei Stromdurchfluss ein magnetisches Feld (H) ausbildet, und
wenigstens einen Körper (9, 10) aus einem elektrisch leitfähigen Material, der zum Bewirken einer Änderung des magnetischen Felds der Spule gegenüber der Spule beweglich angeordnet ist.

2. Element (2) nach Anspruch 1, **dadurch gekennzeichnet, dass** der Körper (9, 10) zum Bewirken der Änderung des magnetischen Felds (H) der Spule (6, 8) durch Änderung eines Abstandes (d) zwischen Spule und Körper ausgebildet ist.

3. Element (2) nach Anspruch 1 oder 2, **dadurch gekennzeichnet, dass** der Körper (9, 10) eine Form aufweist, die ein Ausbilden von Wirbelströmen ermöglicht, wenn sich der Körper in dem magnetischen Feld (H) der Spule (6, 8) befindet.

4. Element (2) nach einem der vorhergehenden Ansprüche, **dadurch gekennzeichnet, dass** der Körper (9, 10) rotationssymmetrisch ist.

5. Element (2) nach einem der vorhergehenden Ansprüche, **dadurch gekennzeichnet, dass** der Körper (9, 10) als Platte ausgebildet ist.

6. Element (2) nach Anspruch 5, **dadurch gekennzeichnet, dass** die Platte (9, 10) mit ihrer Plattenebene im Wesentlichen senkrecht zur Richtung des sich bei Stromdurchfluss durch die Spule (6, 8) ausbildenden magnetischen Felds (H) am Ort der Platte angeordnet ist.

7. Element (2) nach einem der vorhergehenden Ansprüche, **dadurch gekennzeichnet, dass** der Körper (9, 10) in einer Richtung beweglich ist, die im Wesentlichen parallel zur Richtung des sich bei Stromdurchfluss durch die Spule (6, 8) ausbildenden magnetischen Felds (H) am Ort des Körpers ist.

8. Element (2) nach einem der vorhergehenden Ansprüche, **dadurch gekennzeichnet, dass** die Spule (6, 8) aus einem elektrisch leitfähigen Rohr (11) gebildet ist.

9. Element (2) nach einem der vorhergehenden Ansprüche, **dadurch gekennzeichnet, dass** die Spule (6, 8) im Betrieb fluiddurchströmt ist.

10. Element (2) nach einem der vorhergehenden Ansprüche, **dadurch gekennzeichnet, dass** der Körper (9, 10) aus einem Material mit niedrigem spezifischen Widerstand, insbesondere aus Kupfer, gebildet ist.

11. Element (2) nach einem der vorhergehenden Ansprüche, **dadurch gekennzeichnet, dass** der Körper (9, 10) mit einem sich von dem Körper weg, insbesondere senkrecht zur Plattenebene, erstreckenden Abstandeinstellteil (12) versehen ist.

12. Element (2) nach Anspruch 11, **dadurch gekennzeichnet, dass** das Abstandeinstellteil (12) zur Abstandeinstellung an seiner Außenumfangsfläche eine Struktur (13) aufweist, die für ein Zusammenwirken mit einer komplementären Struktur an einem bezüglich der Spule (6, 8) ortsfesten weiteren Element (14) des Anpassungsnetzwerks (1), insbesondere einem Gehäuse für das Anpassungsnetzwerk, ausgebildet ist.

13. Element (2) nach Anspruch 12, **dadurch gekennzeichnet, dass** die Struktur (13) eine Gewindestruktur ist, insbesondere in Form eines Außengewindes.

14. Element (2) nach einem der vorhergehenden Ansprüche, **dadurch gekennzeichnet, dass** der Körper (9, 10) geerdet oder elektrisch isoliert ist.

15. Element (2) nach einem der vorhergehenden Ansprüche, **dadurch gekennzeichnet, dass** eine Mehrzahl von Körpern (9, 10) vorgesehen sind, die jeweils auf unterschiedlichen Seiten bezüglich der Spule (6, 8) angeordnet sind.

16. Anpassungsnetzwerk (1) zum Anpassen einer Eingangsimpedanz eines ersten Schaltungsteils an eine Ausgangsimpedanz eines zweiten Schaltungsteils, aufweisend wenigstens ein Element (2) nach einem der vorhergehenden Ansprüche.

17. Anpassungsnetzwerk (1) nach Anspruch 16, **dadurch gekennzeichnet, dass** das Element (2) in schaltungstechnischer Wechselwirkung mit wenigstens einem Kondensator (5) angeordnet ist.

18. Anpassungsnetzwerk (1) nach Anspruch 16 oder 17, **gekennzeichnet durch** ein Gehäuse (14), insbesondere ein für Hochfrequenzstrahlung dichtes Gehäuse, in dem die wenigstens eine Spule (6, 8) und der wenigstens eine Körper (9, 10) angeordnet sind, wobei eine das Abstandeinstellteil (12) umfassende Abstandeinstelleinrichtung (12, 15, 16) für den wenigstens einen Körper von außerhalb des Gehäuses zugänglich und bedienbar ist.

19. Verwendung des Anpassungsnetzwerks (1) nach einem der Ansprüche 16 bis 18 zum Anpassen der Last einer Plasmaentladungseinrichtung an einen geeigneten Hochfrequenz-Leistungsgenerator.
